# EUROPEAN PATENT SPECIFICATION

(11) **EP 2 087 321 B1**
(45) Date of publication and mention of the grant of the patent: **07.06.2017**
(21) Application number: 07824360.7
(22) Date of filing: 29.10.2007
(51) Int. Cl.: G01D 5/347, H01S 5/026

(54) **OPTO ELECTRONIC READ HEAD**
OPTOELEKTRONISCHER LESEKOPF
TÊTE DE LECTURE OPTOÉLECTRONIQUE

(30) Priority: 28.10.2006 GB 0621487
(43) Date of publication of application: 12.08.2009
(73) Proprietor: Renishaw PLC, Wotton-Under-Edge Gloucestershire GL12 8JR (GB)
(72) Inventor: WESTON, Nicholas, John, Peebles Peebleshire EH45 9DT (GB); MCKENDRICK, Alexander, David, East Kilbride Lanarkshire G74 3JY (GB); CARR, John, Peter, Dunfermline Fife KY11 8LL (GB); DESMULLIEZ, Marc, Philippe, Yves, Edinburgh Lothian EH15 1LW (GB); MCFARLAND, Geoffrey, Wotton-under-edge Gloucestershire GL12 8LD (GB)
(74) Representative: Rolfe, Edward William
(86) International application number: PCT/GB2007/004116
(87) International publication number: WO 2008/053184

(56) References cited:
- EP-A- 1 014 043
- WO-A-00/52766
- DE-A1- 19 917 950
- US-A- 5 155 355
- US-A- 5 926 493
- US-A1- 2003 022 414

## Description

The present invention relates to an opto-electronic encoder readhead used to detected displacement relative to a scale. In particular, it relates to integration and layout of opto-electronic components.

Typically, opto-electronic scale reading apparatus comprise a scale and a readhead moveable relative to one another. The scale is provided with scale markings on a surface thereof and the readhead has a light source to illuminate the scale and a detector to detect a light pattern produced from interaction between light, the scale and any other optical devices provided in the readhead to thereby determine relative motion of the scale and readhead.

One known type of opto-electronic scale reading apparatus for measuring relative displacement of two members is a three grating system which comprises a reflective scale graduation, which is scanned by a readhead comprising an index grating, analyser grating, means of illuminating the scale and photo sensitive elements from which electrical signals are produced. The scale is illuminated by the readhead via the index grating, producing interference fringes at the analyser plane. A light intensity modulation at a given point on the analyser grating results as the fringes move across the analyser grating with the relative movement of the readhead and scale. GB patent No. 1,504,691 discloses one such embodiment of said grating system whereby a Moire fringe pattern is generated over photo detector positioned behind the analyser grating. The photo detectors are configured in a known manner to produce four phase shifted (usually 90° for quadrature method), cyclically varying electrical signals from which the magnitude and displacement of said relative movement is determined. Examples of said method can be found from US patent No. 5,155,355, US 5,302820 and US 6,481,115. Similar methods are described in US 6,476,405 and US 5,661,296, where displacement detection in both x and Y axis and of a scale on a rotary disk are disclosed respectively.

US patent No. 2004/0189984 discloses an optical encoder which uses chip-on-glass (COG) technology to integrate the light source (an LED), the photo detectors and some electronic components onto a common borosilicate glass substrate, achieving a compact construction.

The glass carrier substrate, has gratings etched into a polished stainless steel strip on the bottom side facing the scale so that a three grating system is employed. The optical scanning unit, comprises the LEDs and photo detectors assembled into suitably etched cavity's on an opto-electronic chip support substrate and an application specific integrated circuit, ASIC, for processing of signals output from the photo detectors. The optical substrate and ASIC are then assembled to the glass substrate using flip-chip techniques.

DE19917950 discloses a measuring system comprising a scale and a thin-film sensor including a semiconductor layer into which photodetectors have been integrated. A light emitting diode can be connected with the semiconductor layer. A transparent substrate having one or several graduations can be connected to the semiconductor layer (e.g. by gluing).

US5926493 discloses a distributed feedback (DFB) laser diode formed using lattice matching techniques.

WO00/52766 discloses a semiconductor photodiode formed using lattice matching techniques.

EP1014043 discloses a scanning head comprising a semiconductor substrate with a symmetrical arrangement of photodetectors and a transmission grating on the opposite side from a light source.

US patent 5,155,355 discloses a photoelectric encoder with a read head in which a substrate made of a light emitting element has light receiving portions formed on a surface thereof. The light emitted from the light emitting element is reflected by a reference grating of a main scale and reaches the light receiving portions. The light receiving portions which are formed on the light emitting element at regular intervals function as a grating on the light emission side and since the light receiving portions themselves are formed into a grating, they also function as a grating on the detection side.

The present invention provides read head for a scale reading apparatus, the read head comprising a light source and an array of photodetector elements, wherein said light source and array of photodetector elements are fabricated in a lattice matched semiconductor compound, and wherein the read head includes at least one grating located on the lattice matched semiconductor compound, wherein the lattice matched semiconductor compound forming the light source and an array of photodetectors are provided on a substrate, and wherein the substrate is lattice matched to the semiconductor compound from which the photodetector elements and light source are fabricated.

The light source may comprise at least one light emitting structure fabricated in a semiconductor compound by the addition of epitaxy structures to the surface of the substrate. The light source and array of photodetector elements may be located in different layers of the epitaxy structures. The light source may comprise at least one light emitting structure fabricated in a semiconductor compound by the addition of at least one quantum well structure and barrier and contact layers to said substrate. The at least one quantum well structure may be configured to emit light at the wavelength at which the photodetector is within 60% of its peak responsivity.

Preferably, the read head includes at least one grating, said at least one grating being integrated on one or both of said photodetector and light source elements. The at least one grating may be located on the side of the lattice matched semiconductor compound which is adjacent a scale, when the read head is in use in a scale reading apparatus.

The lattice matched semiconductor compound may be in the III-V family, for example it may comprise compounds of Indium Phosphide or Gallium Arsenide. The lattice matched semiconductor compounds may be tertiary or quaternary compounds. The lattice matched semiconductors forming the light source and an array of photodetectors may be provided on a substrate and wherein the substrate comprises Indium Phosphide.

The lattice matched semiconductor compound may comprise a single crystal of semiconductor.

In one embodiment, electrical contacts are provided on the side of the substrate which is non adjacent the scale when the read head is in use in a scale reading apparatus.

A light emitting element may be provided for producing an optical output signal from the read head. The light emitting element may be integrated with the lattice matched semiconductor compound. An optical fibre may be provided for optical transmission of signals from the read head.

The array of photodetector elements may be distributed in a two dimensional array. The array of photodetector elements may be distributed in a diagonal striped or chevron pattern, for example. Preferably, photodetector elements outputting signals of like phase are electrically connected in common.
2. In one embodiment, the read head is provided with at least one additional photodetector element for the detection of different features from said array of photodetector elements. The at least one additional photodetector element may be integrated with the lattice matched semiconductor compound. The read head may be provided with at least one additional light emitting element for the illumination of different features from said light source. The light emitting element may be integrated with the lattice matched semiconductor compound. In one embodiment, the the axis joining the centres of said additional light emitting element and said additional photodetector element is substantially perpendicular to the direction of relative motion of said readhead and a scale.

An embodiment of the readhead includes an opto-electronic chip comprising a light source for producing light rays; an index grating illuminated by the light source serving as a secondary light source array for producing light rays incident on the scale, defined by a series of spaced apart reflective and non-reflective opaque lines (an alternative method is to use a phase grating where by the grating features differ in height by an odd multiple of a quarter of the wavelength in use causing constructive and destructive interference of the signal) for diffracting readable rays into fringes in at least one order of diffraction; an analyser grating for converting fringes into light modulations at a rate which is a function of the displacement between readhead and scale; and arrays of photo sensitive elements that are divided into sets within sub-cells and are interleaved in a repeating pattern with the outputs of a given set being connected in common. The integrated photonic device can then be bonded using known bonding techniques, such as flip chip bonding or wire bonding, to a substrate (e.g. ASIC, glass carrier or ceramic circuit board), which houses some processing electronics, without obscuring the optical elements. An optical window covers the chip and ASIC to seal the package and provide protection against outside elements. The packaged readhead moves relative to the scale to generate an output signal from which magnitude and direction of said relative movement can be determined.

The prerequisite for substantially reduced footprint and thus increased readhead compactness, in accordance with the present invention, lies with monolithic integration of the optical components, light source, photo detectors and gratings on a common semiconductor substrate. A further advantage is the co-fabrication of the index and analyser gratings over the optical elements using well established lithographic techniques. This results in a one step alignment procedure for all chips over the entirety of the wafer aligning many hundreds of devices simultaneously. Thus the need to individually align light sources and photo detectors to grating patterns, as in US patent 2004/0189984, is removed allowing for reduced processing time, increased through-put and reduced labour costs.

In accordance with the present invention at least one photo detector sub-cell cell is arranged along side at least one light emitting element in a first scanning arrangement. Each sub-cell unit comprises at least two photo sensitive elements.. The generation of the phase shifted signals takes place by means of the spatially defined assignment of the analyser grating over individual detector elements. Detector elements then outputting signals from like phases are electrically connected in common and may be adjusted by electrical amplification. Besides the compactness of the present invention a further advantage results from increasing the number of photo detector elements, in that the adverse effects of contaminant particles, such as dust, appearing on the measuring scale have little effect on the resultant output signal, as the signal has been collected from detector elements at numerous locations, as the signal has been collected from detector elements at numerous locations.

In a preferred embodiment of the monolithically integrated opto-electronic readhead additional detector elements and optionally an additional light source are positioned outside the photo detector sub-cell sub-cell units to perform reference pulse detection and optionally reference marker illumination. An alternative embodiment replaces at least one sub-cell unit with reference detector elements. Reference markings on the measuring scale grating at defined positions are used to generate reference pulse signals at the reference photo detector elements. Various coded markings can be employed to provide an absolute position on the scale.

The combined phase signals (after electrical processing on the ASIC) require transfer to a down stream evaluation unit. This can be performed using, flex flat cables, ribbon cables or conventional cabling and wire bonding. The disadvantages of such approaches include; bulky components and cabling, requires many wires and associated bond sites contributing to bulk and an increased footprint. Generally wires are bonded either individually, which is time consuming, labour intensive and thus costly and requires accurate alignment over each bond site, or by using an automated machine tool which can be an expensive overhead. Therefore, in a further advantageous embodiment of the present invention, the signals are communicated to the evaluation unit by means of optical fibre. As well as constructing a means for illuminating the scale, photo sensitive elements and optical gratings on a common semiconductor substrate a further light emitting element is constructed outside the photo detectors subcell arrays, at the chip edge, and in accordance with the present invention maintains a compact device through monolithic integration. Multiplexed signals corresponding to the, now combined and electronically processed, signals generated by the photo detector elements are fed to said light emitting element. The output of said light emitting element is coupled to an optical fibre for transmission to the evaluation unit.

Transmitting signals over an optical fibre provides further advantages, compared to the aforementioned conventional methods, in that the transmitted signals are not susceptible to electromagnetic interference. It also means that only power to the readhead need be supplied over copper cable. Therefore, as an example, inexpensive plastic optical fibre combined with unshielded power cable could be used, aiding in the objective of the present invention, as it is light weight with a small diameter compared to shielded electrical cable.

The compactness of the opto-electronic readhead can be improved further still. In another preferred embodiment some of the process electronics can be removed from the ASIC and monolithically integrated along with the electo-optical components described onto a single semiconductor chip. Subsequently the size of the ASIC is reduced accordingly. Additionally integration of the processing electronics offers the added benefits of reduced electrical noise as a result of shorter path lengths and the removal of interfaces.

For one skilled in the art it will be understood that the invention can be used in both linear, 2-Dimensional (2D) linear measurement apparatus as described in EP 1106972A1 and rotary measurement apparatus as described in US 5,886,352 hereby included by reference. It will also be understood that the grating periods are by no means constricted to those listed in this document and that different graduation periods are applicable while following the rules mention previously. Furthermore suitable design of the gratings would allow for the use of a non-repeating pattern of photo detectors or photo detectors that are not interleaved.

Embodiments of the invention will now be described in greater detail, by way of example, and with reference to the accompanying drawings, wherein:
Fig. 1 is a cross sectional view illustrating the main sections of an embodiment 1 of the present invention;
Fig. 2 is a cross sectional view of a 2^{nd} preferred embodiment;
Fig. 3 is a cross sectional view of a 3^{rd} preferred embodiment;
Fig. 4 is a cross sectional view of a 4^{th} preferred embodiment;
Fig. 5a and 5b is a cross sectional view of a 5^{th} preferred embodiment;
Fig. 6a and 6b is an enlarged detail of Fig 1 illustrating the construction of a substrate emitting opto-electronic chip, highlighting the integration of light emitting and photo sensitive elements with coplanar contacts;
Fig. 7a and 7b is an enlarged detail of Fig 2 and 3 illustrating the construction of a surface emitting opto-electronic chip;
Fig. 8 is an enlarged illustration of Fig. 1 and 3 highlighting interconnection between the opto-electronic chip and chip carrier (e.g. ASIC, glass or ceramic);
Fig. 9 shows a 1^{st} embodiment of photo detector element layout;
Fig. 10 shows a 2^{nd} embodiment of photo detector element layout;
Fig. 11 shows a 3^{rd} embodiment of photo detector element layout;
Fig. 12 shows a 4^{th} embodiment of photo detector element layout;
Fig. 13 shows a 5^{th} embodiment of photo detector element layout;
Fig. 14 shows a 6^{th} embodiment of photo detector element layout.
Fig. 15 shows a general layout of a 1^{st} embodiment of a reference marker implementation in the present invention.
Fig. 16a and 16b show detail of the grating structures for the incremental scale reading elements in fig. 15.
Fig. 17 shows a general layout of a 2^{nd} embodiment of a reference marker implementation in the present invention.
Fig. 18a and 18b show detail of the grating structures for the incremental scale reading elements in fig. 17.
Fig 19 shows two options for the reference photodetector gratings appropriate to the layouts in figures 15 and 17.
Fig. 20 shows reference marker features within incremental scale appropriate to the detector gratings in figure 19.
Fig. 21 a shows a 2^{nd} embodiment of reference marker features within incremental scale appropriate to the detector gratings in figure 19.
Fig. 22 shows a general layout of a 3^{rd} embodiment of a reference marker implementation in the present invention.
Fig. 23 shows the detailed layout of the reference photo-detectors appropriate to the layout in figure 20.
Fig. 24 shows reference marker features within incremental scale appropriate to the detector layout in figure 22.

The represented drawings are not to scale. All dimensions shown are indicative only.

The opto-electronic readhead according to the invention is described below on the basis of exemplary embodiments used with a linear, 2D linear or rotary measurement system. However, the possibility exists of also using the readhead according to the invention in other graduated scale based measurement systems, without significant modification.

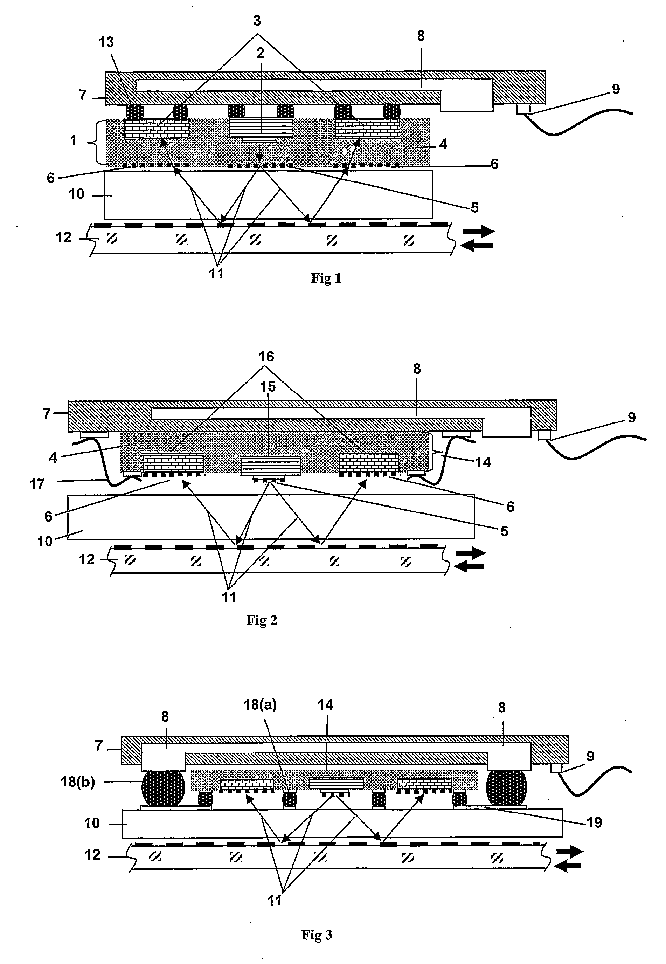

Fig. 1 is a schematic representation showing a partial cross-section view of a first embodiment of the encoder readhead of the present invention. The opto-electronic chip, 1, comprises a light emitting diode, 2, and photo sensitive elements, 3, fabricated in a common semiconductor (e.g. from the III-V family), 4, in this preferred embodiment Indium Phosphide (InP), by means of standard semiconductor manufacture techniques. Index grating, 5 and analyser gratings, 6, are manufactured on the opposite side of the opto-electronic chip, 1, from the light emitting diode and photosensitive elements using standard lithographic techniques. The opto-electronic chip, 1, is flip chip bonded to a suitable substrate (e.g. an Application Specific Integrated Circuit (ASIC), glass carrier or Low Temperature Co-Fired Ceramic Technology (ceramic circuit board), 7, on which conductive traces are also fabricated. The ASIC, 7, includes some processing electronics, 8, such as electronics to perform electrical amplification on the signals output from the photodiodes, and a compilation of wires, 9, to communicate the signal to the outside world.

A glass protective cap, 10, is fixed over the opto-electronic chip, 1. The light rays, 11, emitted from the light emitting diode, 2, propagate in the direction toward the bottom of the opto-electronic chip, 1, hence forth known as the substrate emitting opto-electronic chip, with a wavelength of 1300nm such that the InP substrate, 4, appears transparent. The light rays, 11, pass through the substrate, 4, and interact with the index grating, 5, before passing through the glass protective cap, 10, and onto the reflective scale grating 12. The rays are reflected back into the opto-electronic chip, 1, via the analyser gratings, 6, such that a Moire fringe pattern is created over the photo sensitive elements, 3, for detection. The photo sensitive elements, 3, convert the light into electrical signals which are passed to the processing electronics, 8, on the ASIC, 7, via the flip chip bonds, 13. The signals are then communicated to a down stream evaluation unit by means of wires, 9.

Although InP is used as the substrate, 4, in this embodiment it is by no means restricted to InP and other semiconductor materials, such as GaAs or GaN could be used, or other substrates which are compatible with the epitaxy process and chosen semi-conductor material system for the emitter and detectors. The wavelength of the light emitted from the light emitting diode, 2, must then be selected so as to make the substrate, 4, appear transparent. In the embodiment the index and analyser grating structures are manufactured in, but not restricted to, gold, deposited on the bottom side of the wafer, using standard lithographic or other techniques. Alternatively the grating could be etched directly into the bottom of the substrate, 4.

The integration of the optical components, light emitting element, 2, photo detectors, 3, and optical gratings, 5, 6, lend to a reduction in overall size, footprint, weight and cost. A major contributor to cost reduction is the ability with the present invention to systematically align all gratings, 5, 6, to each light emitting element, 2, and all photo detectors, 3, for every opto-electronic chip, 1, over the entirety of the wafer in one processing step, removing the need for individual placement and alignment of the components and in doing so saving on time and labour.

Fig.2 is a schematic showing a partial cross-section view of a second preferred embodiment of the encoder readhead of the present invention. The elements corresponding to those in the first embodiment are indicated by the same numerals and an explanation thereof will be omitted.

The opto-electronic chip, 14, comprises a light emitting diode, 15, and photo sensitive elements, 16, fabricated in lattice matched semiconductors (e.g. from the III-V family), 4, by means of standard semiconductor manufacture techniques. Index grating, 5 and analyser gratings, 6, are manufactured directly on top of the optical elements, 15,16, using standard lithographic techniques. The opto-electronic chip, 14, is wire bonded to a suitable substrate (e.g. an ASIC, glass carrier or ceramic circuit board), 7, with conductive tracking using gold wire bonds, 17. The ASIC, 7, includes some processing electronics, 8, such as electronics to perform electrical amplification on the signals output from the photodiodes, and a compilation of wires, 9, to communicate the signal to the outside world.

A glass protective cap, 10, is fixed over the opto-electronic chip, 14. The light rays, 11, emitted from the light emitting diode, 15, propagate from the top of the chip, in the direction toward the glass cap, 10, with a wavelength of 1300nm. In this context the propagation is in the opposite direction from opto-electronic chip, 1, illustrated in Fig 1 and will hence forth be known as the surface emitting opto-electronic chip. The light rays, 11, interact with the index grating, 5, before passing through the glass protective cap, 10, and onto the reflective scale grating 12. The rays are reflected back from the scale into the opto-electronic chip, 14, via the glass cap, 10, and analyser gratings, 6, such that a Moire fringe pattern is created over the photo sensitive elements, 15, for detection. The photo sensitive elements, 15, convert the light into electrical signals which are passed to the processing electronics, 8, on the ASIC, 7, via the wire bonds, 17. The signals are then communicated to a down stream evaluation unit by means of wires, 9.

Although InP is used as the substrate, 4, in this embodiment it is by no means restricted to InP and other materials, such as GaAs, GaN, or other substrates which are compatible with the epitaxy process and chosen semi-conductor material system for the emitter and detectors could be used. The wavelength of the light emitted from the light emitting diode, 15, no longer passes through the substrate, 4, and as such the limit of the wavelength spectra is no longer restricted by the optical transparency properties of the substrate, 4. In this embodiment the index and analyser grating structures, 5, 6, are manufactured in, but not restricted to, gold, deposited onto the light emitting diode, 15, and photo sensitive elements, 16, using standard lithographic or other techniques.

Fig.3 is a schematic showing a partial cross-section view of a third embodiment of the encoder readhead of the present invention. The elements corresponding to those in the first and second embodiments are indicated by the same numerals and an explanation thereof will be omitted.

The opto-electronic chip, 14, is also suitable for flip chip bonding and in this preferred embodiment the opto-electronic chip, 14, is flip chip bonded directly onto the glass protective cap, 10, using electroformed gold bumps, 18a, in a Chip on Glass (CoG) arrangement. Predefined bond pads and conductive tracks, 19, manufactured using standard lithography techniques on the glass protective cap, 10, provide electrical connections via a second set of bump bonds, 18b, between the opto-electronic chip, 14, and the ASIC, 7. The ASIC, 7, is bonded over the opto-electronic chip, 14, using larger bumps 18, 18b, ensuring adequate clearance between the opto-electronic chip, 14, and ASIC, 7, while maintaining the compact readhead within the scope of this invention. The wired connection, 9, for signal transfer to a down stream evaluation unit is shown on the ASIC but with only slight modification this connection could easily be located on the glass substrate, 10.

For one skilled in the art it will be understood that various mounting options are available for wire bonding, flip chip bonding, other bonding techniques and combinations thereof are applicable to this invention with only slight modifications. Furthermore it will be understood that the configurations of the optical readheads described are for illustration purposes and are by no way restricted to those detailed in this document e.g. opto-electronic chip, 14, flip chip bonded to the glass, 10, as in fig 3, may also have the ASIC, 7, mounted back to back with the opto-electronic chip, 14, using an epoxy adhesive. Wire bonds could then be used to connect the ASIC to bond pads on the glass, 10, and thus providing interconnection with the opto-electronic chip, 14.

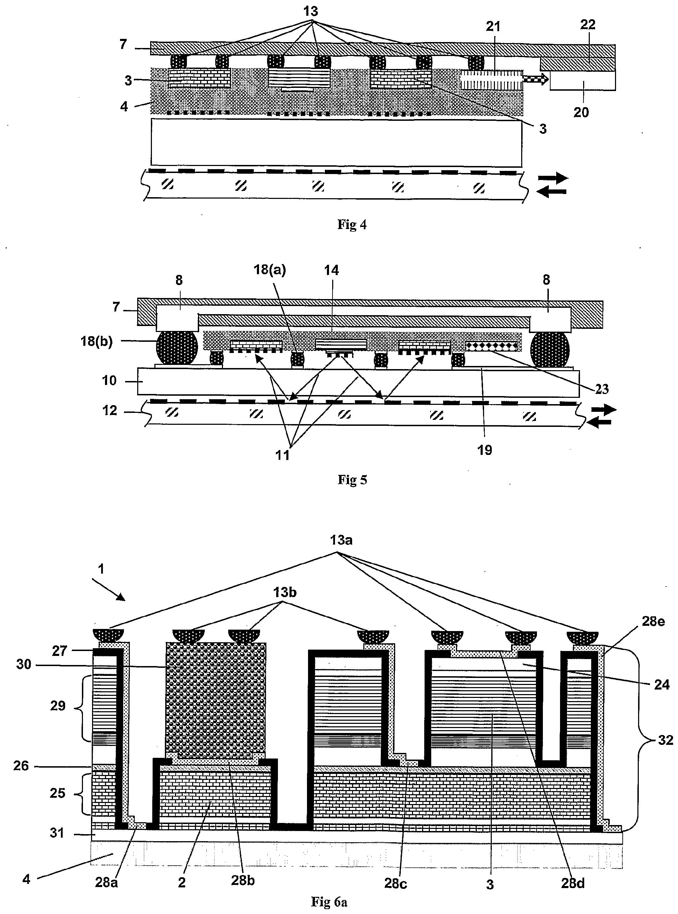

In a further advantageous embodiment of the present invention the signal transfer wire connections, 9, are replaced with an optical fibre, 20, as demonstrated in Figure 4. The elements corresponding to those in the first embodiment are indicated by the same numerals as the first fig. 1 to 3 changed into 4, and an explanation thereof will be omitted. This advantageous embodiment requires the construction of a further light emitting structure, an edge emitting laser diode in this preferred embodiment, 21, is constructed. With modification the direction of light emission can be controlled and it will be understood that the direction shown in Fig. 4 is for illustrative purposes only. The electrical signals generated by the photo detectors, 3, are passed to the processing electronics 8 on the ASIC, 7, with common signals combined. The processed signals are then fed into the edge emitting diode, 21, in multiplexed fashion, so as to maintain the phase difference. The output of the edge emitting diode, 21, is coupled into an optical fibre, 20, for transmission to the outside world. Said edge emitting diode, 21, is manufactured in accordance with the object of the present invention to maintain the compact construction with monolithic integration of the opto-electronic components onto a common semiconductor substrate, 4.

Processing of the signals once again takes place on the ASIC, 7, but by also appropriately combining the signals and feeding them to the laser diode, 21, in a multiplexed manner, in order to preserve the quadrature nature of the signals, the numerous wire connections, 9, are replaced by one single optical fibre, 20. Therefore, the slight extension to the footprint of the opto-electronic chip, 1, 14, is compensated by a reduction of the ASIC, 7, footprint as the need for up to fifteen wire bond sites are replaced by a single fibre alignment trench, 22, such as a V-groove. This also introduces an overall space saving within the packaged readhead at reduced cost. Furthermore signals transmitted in optical fibre are not susceptible to electromagnetic interference and fibres are lightweight, flexible and low in cost, compared to conventional copper cables. There are a number of different multiplexing techniques which may be employed to transmit the signals using a laser diode, which will not be discussed here further.

It will also be understood that the schematic fig 4 is for illustrative purposes and the manufacture of additional light sources and use of optical fibre(s) is not restricted for use with the substrate emitting opto-electronic chip, 1, and is equally applicable to the surface emitting opto-electronic chip, 14, and any modification thereof within the scope of the invention.

Fig 5 is a schematic representation showing a partial cross-section view of another advantageous embodiment of the present invention. The elements corresponding to those in the previous embodiments are indicated by the same numerals and an explanation thereof will be omitted. The figure is for illustrative purposes and as such the inclusion of the optical fibre or wired connection for signal transfer has been omitted but both are equally applicable.

In this embodiment some of the processing electronics, 23, is moved off the ASIC, 7, and monolithically integrated onto said opto-electronic chip, 1, 14. Electrical connections are made either on chip, on substrate, or by a combination of both via bonds, 18, and conductive tracking, 19. It should be noted that although Fig 5 illustrates the surface emitting regime, monolithically integrating said process electronics with the substrate emitting chip, 1, is equally applicable.

Once again the compromise of slightly increasing the footprint of the opto-electronic chip, 1, 14, is compensated by a reduction in the footprint of the ASIC, 7. Furthermore additional light sources as described in fig 4 for optical transfer of the output signals in a fibre, 20, and in accordance with the proceeding layout geometries, may also be fabricated in conjunction with said integrated processing electronics, 23.
One skilled in the art will understand that said integrated electronics, 23, are not restricted to the locations described in this document and can be located at various positions and levels within the opto-electronic chip, 1, 14, structure determined by the manufacturing techniques employed. It will also be understood that in accordance with the present invention said configuration remains compatible with both substrate emitting opto-electronic chip, 1, or surface emitting opto-electronic chip, 14.

The integration of the optical components, light emitting element, 2, 15, photo detectors, 3, 16, optical gratings, 5, 6, and electronics, 23, onto a single chip lend to a reduction in overall size, footprint, weight and cost. A major contributor to cost reduction is the ability with the present invention to systematically align all gratings, 5, 6, to each light emitting element, 2, 15, and all photo detectors, 3, 16, for every opto-electronic chip, 1, 14, over the entirety of the wafer in a single processing step, removing the need for individual placement and alignment of the components and in doing so saving on time and labour. By this means alignments of the emitting elements, photo detectors and associated gratings are achieved on a number of devices simultaneously. The wafer can then be diced into individual opto-electronic chips which require no further alignment steps to their constituent gratings etc. to work as readheads.

Fig. 6a is an enlarged detailed view of Fig. 1 showing the construction of the opto-electronic chip, 1, including the light emitting diode, 2, and photosensitive elements, 3. The epitaxy structure, 32, is deposited on top of the InP substrate, 4 using metal organic phase vapour epitaxy, MOPVE, deposition techniques and comprises two n-type layers, 24, 31, and p-type region, 26, sandwiching optically active areas to form a junction for light emission region, 25, and photo sensitive region, 29. The n-type and p-type layers are electrically connected by metal film electrodes formed from gold deposition, 28, an isolation layer, 27, is deposited to insure appropriate contact to only the required location on the n-type and p-type layers.

The light emitting sections, 25, and photosensitive section, 29, of the opto-electronic chip, 1, are located at different heights within the epitaxy structure, 32. For effective flip chip bonding to the ASIC, (7, Fig 1), a planarised set of bond pads are required. This is achieved by precision controlled electroforming of gold contact posts, 30, onto the p-type contact electrode, 28b, on top of the light emitting region, 2. Contact post, 30, formed on top of each of light emitting elements, 2, 15, also act as a heat sink to that component and provide a large contact surface area for flip chip bonding.

The surfaces of the contact electrodes, 28, and contact post, 30, are suitably prepared for flip chip bonding. The n-type contact bumps, 13a, and p-type contact bumps, 13b, are formed on the ASIC board (or submount), which is not shown in this figure but is illustrated as reference 7 in figure 4. The bumps are electroplated gold posts flip chip bonded using thermo-compression bonding techniques. One skilled in the art will realise that the flip chip bonding assembly is not limited to these techniques and other materials, bumping and attaching methods, such as solder bumping and reflow processes, are applicable. As the emission and detection takes place through the bottom side of the opto-electronic chip, 1, placing all bumps, 13a, 13b, on the top side means that bonding can be performed without obscuring the optical path.

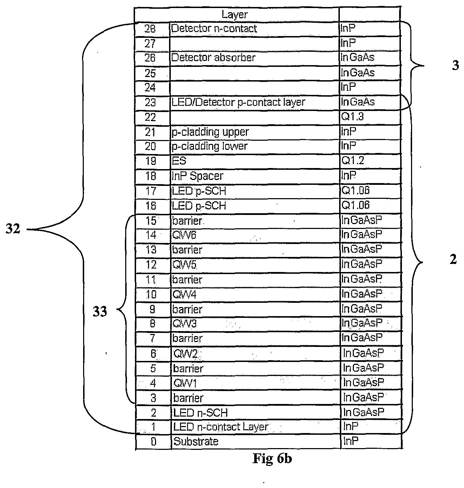

Fig 6b provides further details of an example epitaxy structure based on semiconductor materials lattice matched to an InP substrate. One skilled in the art will recognise that the light emitting active region, 2, within the epitaxy structure, 32, is formed by growing a number of very thin layers with low electronic bandgap between layers of materials with higher electronic bandgap, thus forming a multiple quantum well structure, 33. In accordance with the present invention a quantum well structure provides benefits over traditional pn-junctions such as reduced current requirements, increased quantum efficiency, reduced optical losses and increased optical power. The quantum well layer, being thin, confines electrons and holes spatially resulting in very tightly quantised energy levels. By careful control of the layer thickness in the quantum well structure the energy levels and therefore the wavelength of the light emitted from the active region can be selected. In this application the emission wavelength is selected such that it matches the peak optical responsivity of the photosensitive elements within the range possible by means of quantum well tuning. This provides another significant advantage to the use of an emission structure of this type over a bulk emission structure as it can significantly improve the overall efficiency of the device. It therefore requires less power to operate reducing thermal effects and increasing device lifetime. It will be understood that the epitaxy structure is not restricted to that illustrated and changes to semiconductor materials, substrate materials, number of quantum wells, layer thickness and emission wavelength are not beyond the scope of this invention.

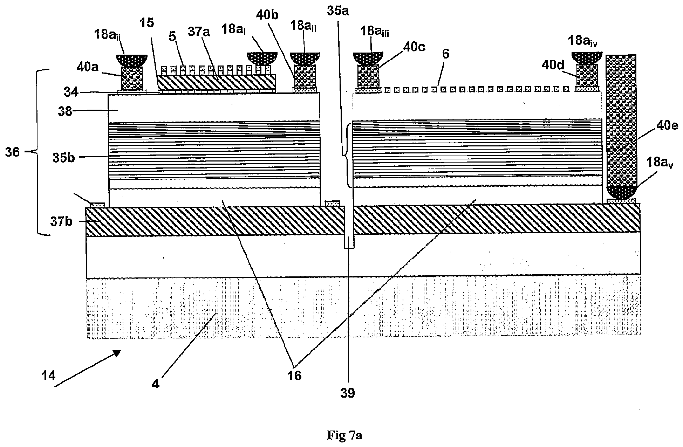

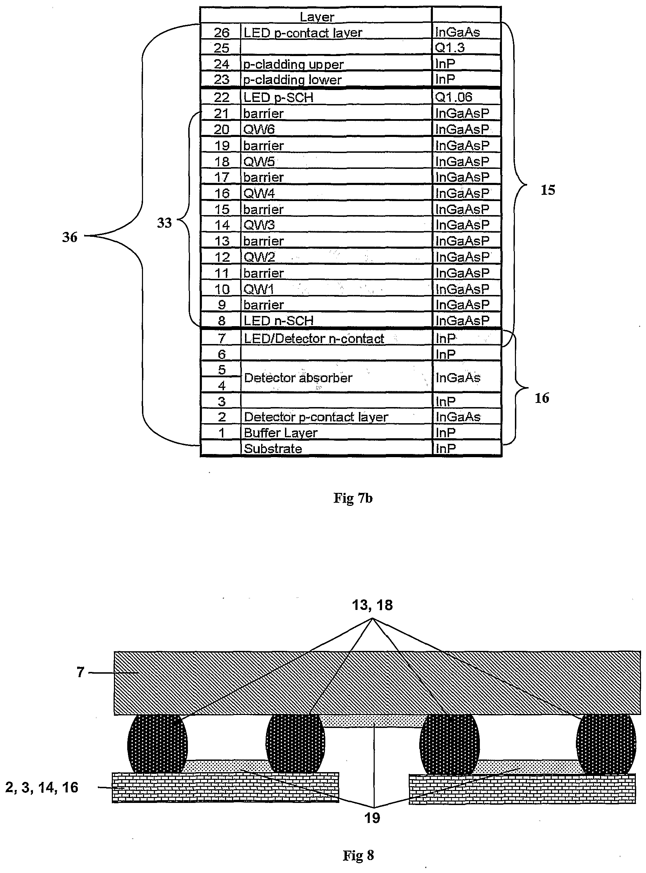

Fig 7 is an enlarged detailed view of fig 2 in accordance with the construction of the opto-electronic chip. Where as the opto-electronic chip of fig 6 utilises a structure where by the light emission propagates first through the substrate in a substrate emitting opto-electronic chip arrangement, the opto-electronic chip, 14, as shown in fig 2 includes a light emitting elements, 15, located above the photosensitive elements, 16, in a surface emitting capacity.

The epitaxy structure, 36, is deposited on top of the InP substrate using MOPVE deposition techniques and comprises two polarised p-type layers, 37a, 37b, and an n-type layer, 38, sandwiching optically active areas to form a junction for light emission region, 34, and photo sensitive regions, 35a and 35b.

Fig 7b provides further details of an example epitaxy structure based on to InP substrate. One skilled in the art will recognise that the light emitting active region, 34, within the epitaxy structure, 36, is formed by growing a number of very thin layers with low electronic bandgap between layers of materials with higher electronic bandgap, thus forming a quantum well structures, 33.

As illustrated in Fig 7A, the light emitting element, 15, is located above the photosensitive region 35b. The photosensitive region, 35b, located directly below the light emitting active region does not constitute a photo detector in the context of the invention. The light emission region, 34, and photosensitive section, 35b, are isolated from the photosensitive regions, 35a, constituting the photo detector locations by means of an isolation trench, 39, in the p-type layer 37b. However the photosensitive region, 35b, located directly beneath the light emission region, 34, may be used to monitor the light emitting region when appropriate connections are made to the p-type layer, 37b. The photosensitive region 35b directly below the emission region 34 also serves the essential purpose of absorbing light generated in the emission region which does not pass through the grating 5 directly above it. Were this light not absorbed or otherwise blocked it would pass into the substrate, 4, which could effectively act as a light guide and channel this stray light into the photo detector locations 35a, without being modulated by the scale, 12. This would be a constant background illumination over all the photo detector channels and would constitute an undesirable DC offset to the AC signal which may cause complications in amplifier design or even saturate the photo detector regions entirely. It is therefore highly advantageous to interpose the detector region between the emitter region and substrate in the surface emitting embodiment.

It should be noted that whilst the preferred embodiments use an InP lattice matched regime for the epitaxy structure, with its associated ternary (InGaAs) and quaternary compounds (InGaAsP), to one skilled in the art it is equally valid to implement these embodiments in other semi-conductors which can be appropriately lattice matched. Examples include GaAs, with associated lattice matched compounds such as AlGaAs, and AlGaInP, and also GaN with associated lattice matched compounds such as GaInN. It is also known, in particular with the GaN system, to deposit the epitaxy structure onto substrates which are not themselves crystalline lattice matched, such as sapphire, silicon carbide and silicon. Such variations on the preferred embodiment are not outside the scope of the present invention.

Referring to Fig 7A, the light emitting section, 34, and photosensitive section, 35a of the surface emitting opto-electronic chip, 14, are located at different heights within the epitaxy structure, 36. For effective flip chip bonding a planarised set of bond pads are preferred. This can be achieved using precision controlled electroforming of the bumps to offset for the difference. As illustrated the bumps may be formed on either the opto-electronic chip, 40a to 40d, or on the carrier glass or ASIC substrate, 40e, or a combination of both. The bumps, 18b, of fig 5 connecting the ASIC to the glass are not shown here. As wire bonding does not require a planarised set of bond pads no height adjustment is necessary when this technique is employed.

Additionally, in this preferred embodiment of the surface emitting opto-electronic chip, 14, the index grating, 5, and analyser grating, 6, are fabricated directly on top of the corresponding optical components. Therefore grating metallisation also provides a contact to the polarised regions covering a larger surface area improving the conductive path for the given component.

In this preferred embodiment the bumps are electroformed gold pillars formed on both the ASIC and glass carrier substrate. The bonds are made using thermo-compression bonding techniques. However, one skilled in the art will realise that the flip chip bonding assembly is not limited to these techniques and other materials, bumping and attaching methods, such as solder bumping and reflow processes, are applicable.

Fig 7b provides further details of an example epitaxy structure based on semiconductor materials lattice matched to InP for a surface emitting optical chip, 14.

One skilled in the art will recognise that the LED, 15, within the epitaxy structure, 36, is formed by growing a number of very thin layers with low electrical bandgap between layers of materials with higher electrical bandgap, thus forming a multiple quantum well structures, 33. In accordance with the present invention a quantum well structure provides benefits over traditional pn-junctions such as reduced current requirements, increased quantum efficiency, reduced optical losses and increased optical power. The quantum well active layer, being thin, confines electrons and holes spatially resulting in very tightly quantised energy levels. By careful control of the layer thickness in the quantum well structure the energy levels and therefore the wavelength of the light emitted from the active region can be selected. In this application the emission wavelength is selected such that it matches the peak optical responsivity of the photosensitive elements within the range possible by means of quantum well tuning. This provides another significant advantage from the use of an emission structure of this type as it can significantly improve the overall efficiency of the device. It therefore requires less power to operate reducing thermal effects and increasing device lifetime. It will be understood that the epitaxy structure is not restricted to that illustrated and changes to semiconductor materials, number of quantum wells, layer thickness and emission wavelength are not beyond the scope of this invention

As detailed in fig 1 through 7 bumps are formed for joining various arrangements of opto-electronic chip, 1, 14, ASIC, 7, and glass cap, 10. Fig 8 is an enlarged illustration highlighting said bumps, 13, 18. These bumps, 13, 18, not only provide a means of bonding parts but also provide electrical interconnection when used in conjunction with electrical conductive tracks, 19, formed on each of the assembled parts. Sharing of the interconnections and distribution of tracks, 19, over the real estate of each part (opto-electronic chip, 1, 14, ASIC, 7, and/or glass cap, 10) in this way allows for extremely compact arrangements to be implemented.

Furthermore the stand-off space between the opto-electronic chip, 1, 14, and substrate, in the case of flip chip bonding, created by the height of the bumps, 13, 18, may be filled using suitable underfill. Underfill can improve the mechanical integrity of the bonded structures thus improving the reliability of the bumps. Alternatively conductive underfill adhesive can be used with the flip chip bonding process.

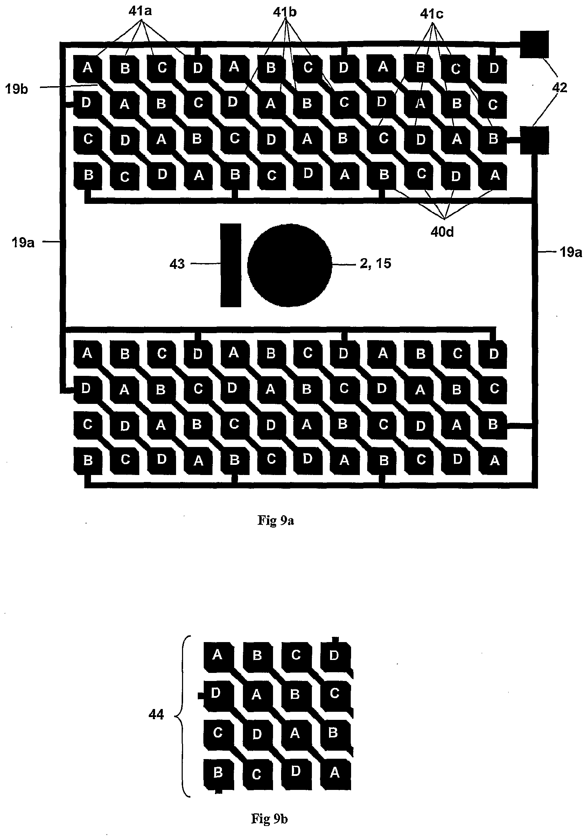

Fig 9 shows a first embodiment of a photo detector layout, used within the preferred embodiment whereby the elements corresponding to those in the first embodiment are indicated by the same numerals as the first fig. 1 to fig. 8 changed into 9, and an explanation thereof will be omitted. The scanning unit of the present invention, with connection tracks 19, partially connecting appropriate common signals together on chip. Common electrical signals relating to the spatially defined positioning of the analyser gratings, 5, are finally all combined on the ASIC, 7, so where connections are not shown in the proceeding embodiments it will be understood that appropriate bonding to and tracking on the ASIC, 7, in each embodiment will complete the combination of common signals.

Fig 9a shows a first preferred embodiment of a photodiode layout arrangement. The photodiodes are arranged in ABCD arrays, 41, which are further arranged into four by four subcell units, 44 Fig 9b, comprising sixteen photosensitive elements equally spaced apart. Six repeats, three either side of a centrally located light emitting diode, 2, 15 and contact pillar, 43, complete this arrangement. Fig 9b shows an enlarged view of one subcell unit, 44. In the embodiment illustrated the square photodiodes have tapered corners allowing for more relaxed tolerances in fabrication accuracy between diagonal tracks and adjacent photodiodes, compared to the same layout with completely square shaped photodiodes, while still offering increased sensitivity. It will be understood that such geometries, of this and proceeding embodiments and in accordance with the present invention, are not restricted to the shapes and dimensions described in this document.

The letters ABCD represent the phase shifted signals generated by the interaction of the light rays, 11, with the gratings, 5, 6, 12, which are detected by that particular photodiode. Appropriate positioning of the analyser gratings, 6, over each photo detector subcell, 44, generates bright and dark fringes, and therefore associated electrical signals, shifting to the right as we move from the first ABCD array, 41a down to the last array, 41d, within each subcell unit, 44. Shifting in such a manner allows for diagonal interconnection tracks, 19b, to be positioned between like detected signals utilising the footprint available for combining each of the signals. Where tracks, 19, can not be laid without compromising the layout or expanding the footprint further the electrical signals are passed to tracks on the ASIC, 7, via the flip chip bump, 13, 18, as shown in fig. 8 or wire bonds, 17 as shown in fig 2. The bonds are made either directly on to a photo detector diode, 41, or on to predetermined bond sites, 42. Further tracks on the ASIC, 7, within the footprint of the opto-electronic chip, 1, 14, to maintain compactness, insure each like signal are combined before being led into the processing electronics.

In accordance with the present invention the embodiment of Fig. 9a has a total of ninety-six photosensitive elements, twenty-four for each of the four phases. Collecting the signals from numerous locations means that adverse effects of contaminant particles causing obstructions in the optical path, such as dust, have little effect on the resultant output signal.

The overall size of the opto-electronic chip, 1, 14, is 2mm² (may extend to 2.5mm² with the embodiment incorporating an optical fibre, 20, and integrated electronics, 23). These dimensions are somewhat restricted by the processing capabilities available at time of manufacture and can be reduced as these capabilities are improved.

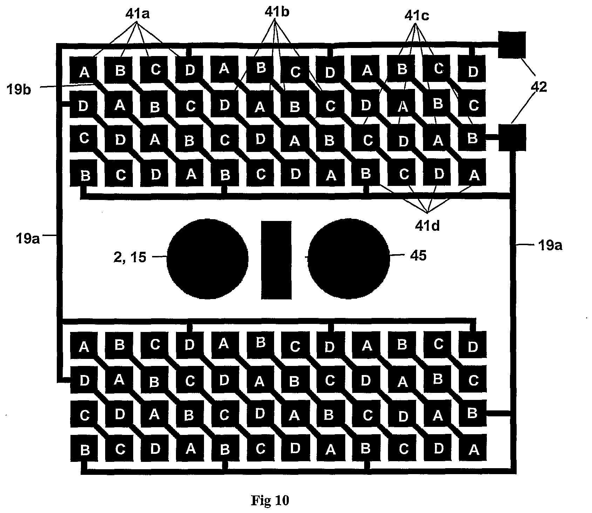

Fig. 10 shows a second advantageous embodiment in accordance with the photodiode layout of the present invention. The elements corresponding to those in the first embodiment are indicated by the same numerals and an explanation thereof will be omitted.

In this embodiment an additional light emitting element, 45, being either substrate emitting or surface emitting in accordance with the preferred arrangements of the present invention, is positioned next to a first light emitting element, 2, 15, and connected in series so that the one input voltage can be dropped over the two light emitting elements. The light emitting devices are located equi-distant from the centre of the opto-electronic chip, 1, 14 to ensure an even light distribution over the photo detector subcells, 44, located along side the light emitting elements, 2, 15, 45.

The additional light emitting element, 45, behaves in identical fashion to the original light emitting element, 2, 15, emitting towards the reflective scale grating, 12. The additional light emitting element, 45, boosts the optical power received at each photo detector elements within all ABCD arrays, 41, resulting in the generation of stronger electrical signals. It is to be understood that, within the restrictions of the opto-electronic chip dimensions of the present invention, further light emitting elements may be introduced with the purpose of increasing the optical power received at the photodiodes. It should also be understood that, in accordance with the present invention, the geometries of the light emitting elements 2, 15, 45, are not restricted to those detailed in this document.

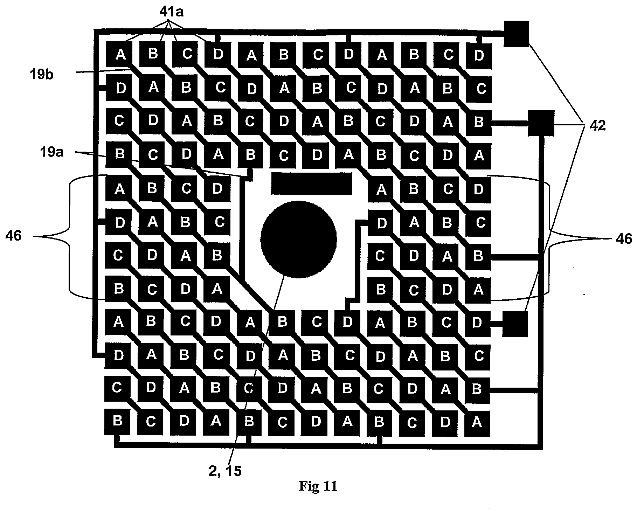

Fig. 11 shows a third advantageous embodiment in accordance with the present invention. The elements corresponding to those in the first and second embodiments are indicated by the same numerals as Figs. 9 and 10 and an explanation thereof will be omitted.

In this embodiment two additional photo detector subcell units, 46, are positioned to the left, 46a, and to the right, 46b, of a centrally located light emitting element, 2, 15, so that it is now encircled by eight repeats of the photodiode subcell units, 44. The photo detectors within the subcell units, 44, generating common signals are combined through diagonal tracks, 19b, and additional perimeter tracks, 19a, where possible. Full combination of common signals is completed on the ASIC, 7.

Each additional subcell unit, 46, increases the overall useful detection area, increasing the amount of photo current generated by the detectors. This also provides an extra eight detector locations improving sensor insensitivity to signal loss as a result of obstructions in the optical path, such as dust or dirt.

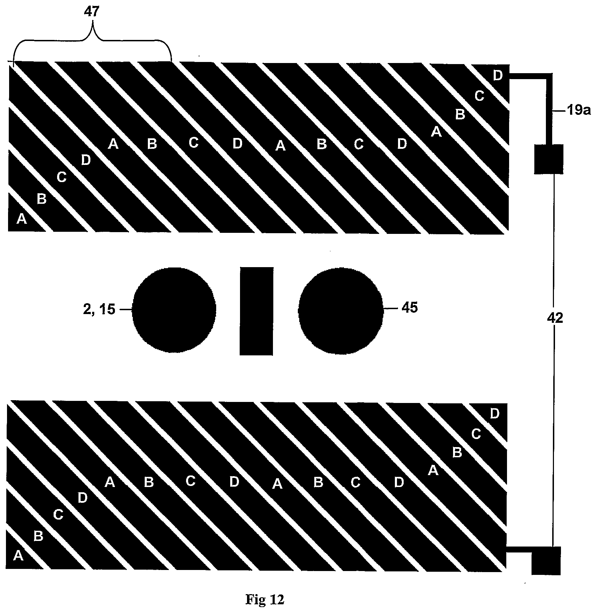

Fig. 12 shows yet another advantageous embodiment of the present invention. The elements corresponding to those in the previous embodiments are indicated by the same numerals as Figs. 9 to 11 and an explanation thereof will be omitted.

In this embodiment the interconnection problem between the photodiodes is overcome by integrating both interconnection tracks and corresponding photodiodes into one entity. The photodiodes comprising each ABCD array occupy the whole diagonal area (where tracks, 19b, were used in the previous embodiments) in a skewed detector arrangement, 47. The arrays are repeated eight times, four times either side of the light emitting elements, 2, 15, 45. The geometries of the diodes are such that the overall areas are increased, over the same given footprint, generating more photo-current per mm² of usable photo detector area, thus increasing the strength of the electrical signals generated by the photo detectors, 3, 16. The areas of diodes 16 contributing to all the relevant ABCD phased signals are equal. Again final combination of the signals takes place on the ASIC, 7, following bonds, 13, 17, 18, directly onto the photo detectors or at predefined locations, 42.

This embodiment therefore has similar robustness to single line scale defects in the optical path between the light emitting elements, 2, 15, 45, scale, 12, and photo detectors, 3, 16, as the signal is still effectively being detected at the same multiple locations as with the previous embodiments.

The alignment of the index, 5, and analyser, 6, gratings using a back side alignment process is now a trivial issue as the tolerances for the linear (X-Y) alignment of the gratings is much larger compared to the preceding embodiments, Fig. 9 to Fig. 11, the angular tolerances are the same but these are easily achieved.

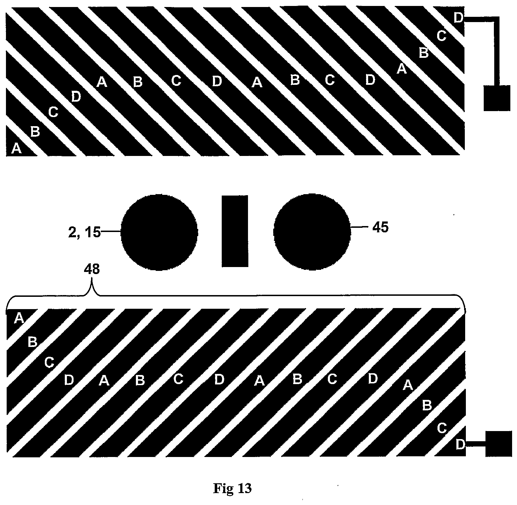

Fig. 13 shows an advantageous embodiment in accordance with the photodiode layout of the present invention. The elements corresponding to those in the first embodiment are indicated by the same numerals as the first Fig. 12 changed into 13, and an explanation thereof will be omitted.

In this embodiment one set of diagonal photo detector strips, 48, on one side of the light emitting source, 2, 15, 45, are flipped creating a chevron style layout. This improves insensitivity against defects that have the same orientation as a diagonal detector strip so that it only completely eliminates the photo diode on one side rather than on both.

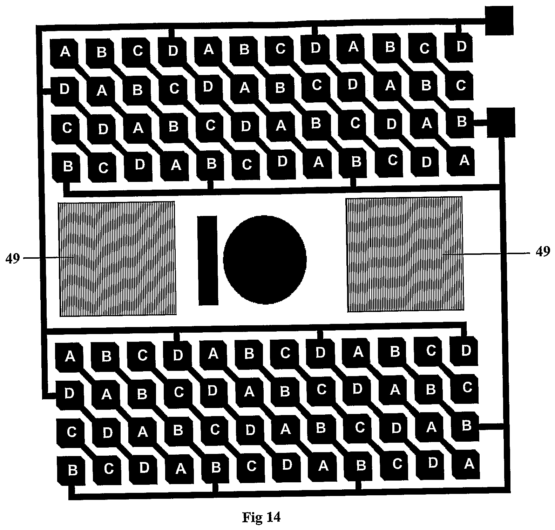

Fig. 14 shows a further advantageous embodiment, applicable to each of the preceding embodiments, in accordance with the photodiode layout of the present invention. The elements corresponding to those in the first embodiment are indicated by the same numerals as Figs. 9 to 13 changed into 14, and an explanation thereof will be omitted.

In this embodiment additional detector elements, reference detectors, 49, are positioned outside the photo detector subcell units, 44, in the vacant space at the side of the light emitting diode, 2, 15, 45, to perform reference pulse detection. Reference markings on the measuring scale grating, 12, at defined positions generate reference pulse signals at the reference detector elements, 49. Various coded markings can be employed to provide absolute position information on the scale, 12. It will be understood that the location of the reference detectors will differ with each given photodiode arrangement and this location is not restricted to the area and following embodiments detailed in this document.

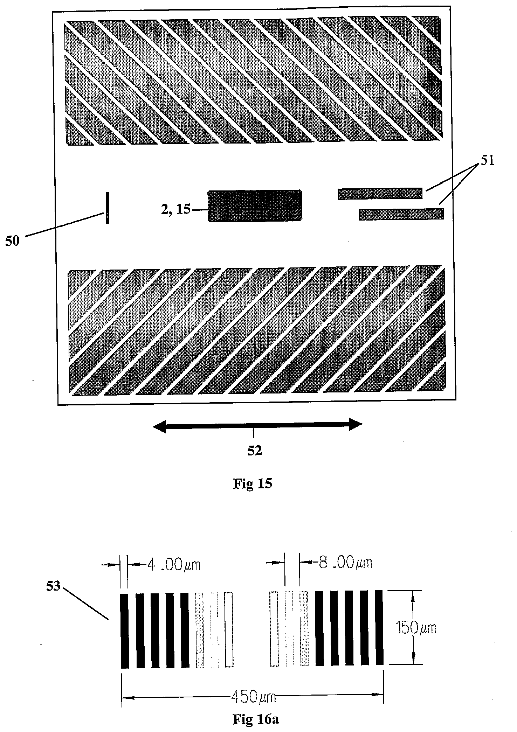

Fig. 15 shows a further advantageous embodiment, applicable to each of the preceding embodiments, in accordance with the photodiode layout of the present invention. The elements corresponding to those in the first embodiment are indicated by the same numerals as Figs. 9 to 14 changed into 15, and an explanation thereof will be omitted.

In this embodiment an additional reference marker light emitting diode, 50, is to one side of the incremental scale light emitting diode, 2, 15, , and reference marker detectors, 51, are to the opposite side. The reference mark detectors, 51, have substantially identical opaque and transparent masks over their active areas; said mask being substantially a magnified form of the reference mark pattern on the scale such that each reference mark photo detector performs an autocorrelation with the projected pattern. The two reference mark photo detectors, 51, are slightly offset relative to each other in the direction of relative motion of the readhead and scale, indicated by the arrow, 52, such that each photo detector produces a pulse output at a slightly different position of the readhead relative to the scale. These two pulses are processed electronically to produce a unique reference pulse. The detailed performance of the reference mark light emitting diode, 50, reference mark detectors, 51, and the corresponding reference mark pattern on the scale is described in US patent number 2006/0283035.

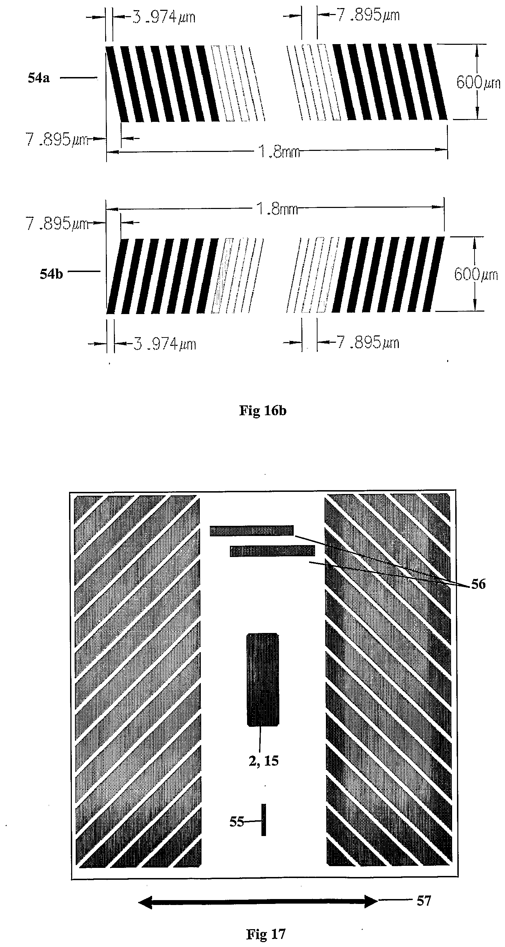

Fig. 16a shows the index grating pattern, 53, with indicative dimensions. Only part of the regular grating pattern is shown for clarity. Fig. 16b shows the analyser grating patterns, 54, for the incremental scale photo detectors with indicative dimensions.
Only part of the regular grating pattern is shown for clarity. The analyser grating pattern described here has an upper part, 54a, and a lower part, 54b, to correspond with the photodiode array layout described by fig 15 and 16 are for illustrative purposes only. The angle of the grating lines is chosen such that the Moire fringe pattern formed between the grating and the diffraction pattern formed by the index and scale are ideally parallel to the photo detectors, 41, 47, 48. The metal lines of the analyser grating are broken where they cross the gap between adjacent photo detector elements to maintain electrical isolation between said photo detectors.

It will be understood that the requirement to break the lines of the analyser grating applies only to the surface emitting opto-electronic chip, 14, and to maintain electrical isolation between adjacent photo detector elements. Where the isolation between adjacent photo detector elements can be achieved by some other means (e.g. using a substrate emitting opto-electronic chip) the metal lines of the analyser gratings do not need to be broken. Furthermore it will be understood that the reference grating patterns, reference light source and reference photo detectors detailed in this and proceeding embodiments are for illustrative purposes and are not restricted to those detailed in this document. Indeed many more reference mark schemes could be employed in accordance with the present invention.

Fig. 17 shows a further advantageous embodiment, applicable to each of the preceding embodiments, in accordance with the photodiode layout of the present invention. The elements corresponding to those in the first embodiment are indicated by the same numerals as the first Fig. 9. to Fig. 15 changed into 17, and an explanation thereof will be omitted.

In this embodiment the reference mark light emitting diode, 55, and reference mark photo detectors, 56, lie on an axis substantially perpendicular to the direction of relative motion, indicated by the arrow, 57, between the readhead and the scale. This reduces the sensitivity of the reference mark to errors in pitch angle between the readhead and scale while maintaining substantially the same sensitivity to roll angle errors and yaw angle errors between the readhead and scale as in the preceding embodiment, Fig. 15.

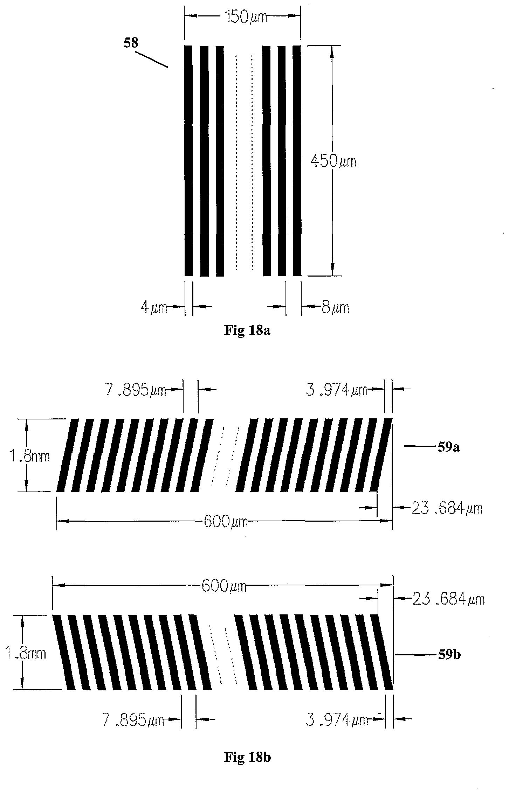

Fig. 18a shows the index grating pattern, 58, with indicative dimensions. Only part of the regular grating pattern is shown for clarity. Fig. 18b shows the analyser grating patterns, 59, for the incremental scale photo detectors with indicative dimensions. Only part of the regular grating pattern is shown for clarity. The analyser grating pattern described here has two parts one to the right hand side, 59a, and one to the left hand side, 59b, of the axis running perpendicular to the direction of relative motion, to correspond with the photodiode array layout described by fig 17 and is for illustrative purposes only. The elements corresponding to those in the preceding embodiment are indicated by the same numerals as the first Fig. 16 changed into 18, and an explanation thereof will be omitted.

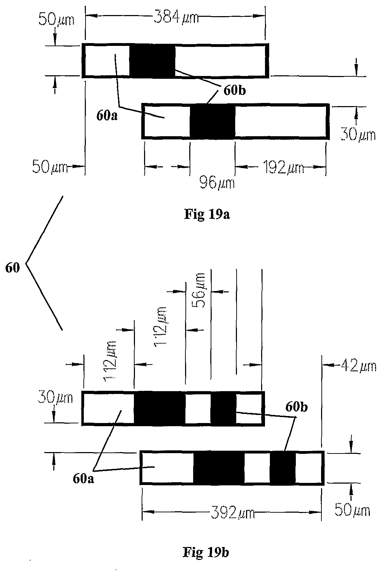

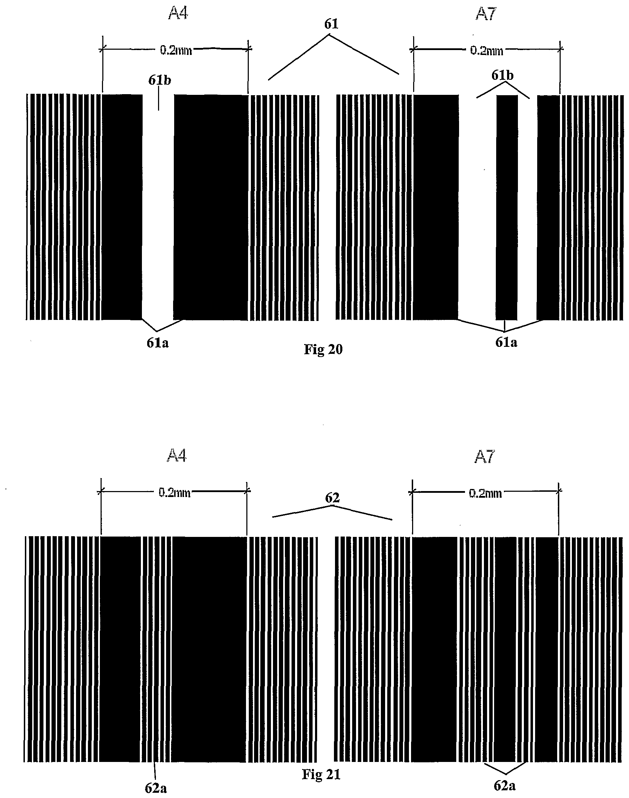

Fig. 19 shows two preferred embodiments of the reference mark opaque and transparent mask pattern, 60, over the active areas of the reference mark photo detectors, 51, 56, including indicative dimensions. Fig 19a demonstrates a 4-bit autocorrelation option while fig 19b demonstrates a 7-bit autocorrelation option. Fig. 20 shows the corresponding preferred embodiments of the reference mark pattern on the scale, 61. The transparent areas, 60a, of the mask pattern over the reference mark photo detectors, 60, correspond to reflective regions, 61a, of the scale and the opaque areas, 60b, of the mask pattern over the reference mark photo detectors correspond to non-reflective regions, 61b, of the scale. The size of the reference mark pattern on the scale, 61, in the direction of relative movement of the readhead and scale is less than the corresponding dimension for the mask pattern over the active area of the photo detectors, 60, to account for the divergence of the rays from the reference mark light emitting diode, 50, 55. The corresponding size of the mask pattern over the reference mark photo detectors, 60, is such that each feature is an integer multiple of the fringe pattern formed by the interaction of the rays of light from the incremental light emitting diode, 2, 15, the index grating, 5, and the scale, 12, thereby making the reference mark photo detectors, 51, 56, insensitive to said fringe pattern.

Fig. 21 shows a further advantageous embodiment of the reference mark pattern on the scale, 62. The elements corresponding to those in the preceding embodiment are indicated by the same numerals as the first Fig. 20 changed into 21, and an explanation thereof will be omitted. In this embodiment the previously non-reflecting regions are replaced with regions containing a continuation of the scale pattern, 62a. When the scale is in the form of a phase grating where the features differ in height by an odd multiple of a quarter of the wavelength of the light emitted by the reference mark light emitting diode, 51, 55, rays from the reference mark light emitting diode are diffracted such that the energy in the zero order reflection is minimised such that when the readhead is in the vicinity of the reference mark features on the scale a magnified image of the reference mark pattern is formed in the vicinity of the reference mark photo detectors. By this means disruption to the incremental signal in the region of the reference marker is reduced.

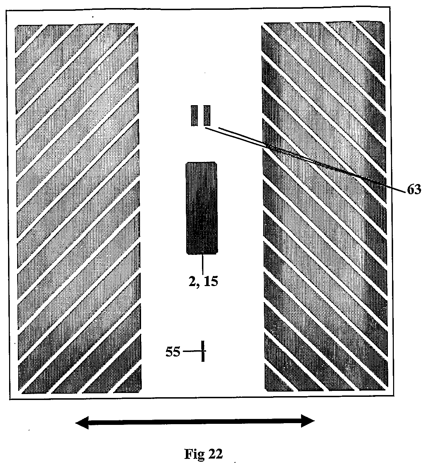

Fig. 22 shows a further advantageous embodiment, applicable to each of the preceding embodiments, in accordance with the photodiode layout of the present invention. The elements corresponding to those in the previous embodiment are indicated by the same numerals as in Figs. the first Fig. 9 to 17 changed into 22, and an explanation thereof will be omitted.

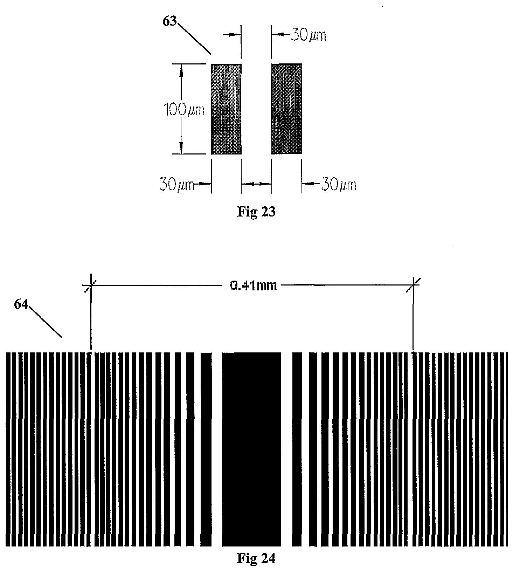

In this embodiment the reference mark features on the scale form a zone plate designed so as to form a stripe of light parallel to the long axis of the reference mark photo detectors, 63, and of a width substantially similar to the spacing between said reference mark photo detectors, 63. Fig. 23 shows the preferred embodiment of the reference mark photo detectors, 63, including indicative dimensions. Fig. 24 shows the preferred embodiment of the zone plate on the scale, 64, including indicative dimensions.

While the pulse output from the reference mark photo detectors, 63, is different from that of the previous reference marks, 51, 56, they can be processed electronically in a substantially similar manner to provide a unique reference pulse.

It will be understood that the use of reference markers and reference marker detectors are not limited to the illustrated embodiments and are applicable to all embodiment of the present invention and variations thereof. It will also be understood in accordance with the present invention that the shapes and dimensions of said reference marker detectors can be easily modified so as to comply with the specific layout arrangement of the opto-electronic chip, 1, 14.

Each of the preferred embodiments detailing detector layouts are suitable for use within the preferred embodiments described by Fig. 1 to Fig. 8. In the embodiments detailing the photodiode layout arrangements described by Fig. 9, to Fig. 14, the light emitting elements are circular in shape with a diameter of 300*µ*m and the photodiodes are 100*µ*m x 100*µ*m squares spaced apart by 30*µ*m gaps or by diagonal strips 100*µ*m and of varying lengths. However it will be understood that the layout arrangements of the present invention are not restricted to these dimensions and shapes as illustrated by the LED geometry detailed in fig 15, 17 and 22.

Although the embodiments described above relate to linear scales and readheads, it will be understood that the invention is also applicable to other scale and readhead systems, for example rotary and two dimensional systems.

Furthermore, while preferred embodiments of the invention have been described, it will also be understood that various modifications may be made thereto, and it is intended that the appended claims cover all such modifications as fall within the scope of the invention.

The embodiments described above provide an optical encoder readhead having monolithically micro integrated optical, electrical and opto-electrical components which produce a small size, light weight device, removing the need for complex expensive alignment and placement procedures and assure performance improvements.

## Claims

1. A read head for a scale reading apparatus, the read head comprising a light source (2) and an array of photodetector elements(3), wherein said light source and array of photodetector elements are fabricated in a lattice matched semiconductor compound (1), and wherein the read head includes at least one grating (5, 6) located on the lattice matched semiconductor compound, wherein said lattice matched semiconductor compound forming the light source (2) and an array of photodetectors (3) is provided on a substrate (4), and wherein said substrate (4) is lattice matched to the semiconductor compound from which the photodetector elements (3) and light source (2) are fabricated.

2. A read head according to any preceding claim wherein the light source (2) comprises at least one light emitting structure fabricated in a semiconductor compound by the addition of epitaxy structures to the surface of the substrate (4).

3. A readhead according to claim 2 wherein the light source (2) and array of photodetector elements (3) are located in different layers of the epitaxy structures.

4. A read head according to any preceding claim wherein the light source (2) comprises at least one light emitting structure fabricated in a semiconductor compound by the addition of at least one quantum well structure and barrier and contact layers to said substrate.

5. A read head according to claim 4 wherein the at least one quantum well structure is configured to emit light at the wavelength at which the photodetector is within 60% of its peak responsivity.

6. A read head according to any preceding claim, said at least one grating (5, 6) being integrated on one or both of said photodetector (3) and light source (2) elements.

7. A read head according to claim 6 wherein the at least one grating (5, 6) is located on the side of the lattice matched semiconductor compound which is adjacent a scale, when the read head is in use in a scale reading apparatus.

8. A read head according to any preceding claim wherein the lattice matched semiconductor compound is in the III-V family.

9. A read head according to claim 8 wherein the lattice matched semiconductor compound comprises compounds of Indium Phosphide or Gallium Arsenide.

10. A read head according to any preceding claim wherein a light emitting element (21) that is integrated with the lattice matched semiconductor compound is provided for producing an optical output signal from the read head.

11. A read head according to any preceding claim wherein an optical fibre (20) is provided for optical transmission of signals from the read head.

12. A read head according to any preceding claim wherein the array of photodetector elements (3) are distributed in a two dimensional array.

13. A read head according to any preceding claim wherein the array of photodetector elements (3) are distributed in a diagonal striped pattern or in a chevron pattern.

14. A read head according to any preceding claim wherein photodetector elements (3) outputting signals of like phase are electrically connected in common.

15. A read head according to any preceding claim wherein the read head is provided with at least one additional photodetector element that is integrated with the lattice matched semiconductor compound for the detection of different features from said array of photodetector elements.

16. A read head according to any preceding claim wherein the read head is provided with at least one additional light emitting element that is integrated with the lattice matched semiconductor compound for the illumination of different features from said light source.

17. A read head according to claim 16 wherein the axis joining the centres of said additional light emitting element and said additional photodetector element is substantially perpendicular to the direction of relative motion of said readhead and a scale.

18. A scale reading apparatus comprising:
a scale (12); and
a read head according to claim 1.

## Patentansprüche

1. Lesekopf für eine Skalenlesevorrichtung, wobei der Lesekopf eine Lichtquelle (2) und ein Feld aus Fotodetektorelementen (3) umfasst, wobei die Lichtquelle und das Feld aus Fotodetektorelementen in einer gitterangepassten Halbleiterzusammensetzung (1) hergestellt sind, und wobei der Lesekopf zumindest eine Rasterung (5, 6) aufweist, die an der gitterangepassten Halbleiterzusammensetzung angeordnet ist, wobei die gitterangepasste Halbleiterzusammensetzung, die die Lichtquelle (2) und ein Feld aus Fotodetektoren (3) bildet, an einem Substrat (4) vorgesehen ist, und wobei das Substrat (4) an die Halbleiterzusammensetzung gitterangepasst ist, aus der die Fotodetektorelemente (3) und die Lichtquelle (2) hergestellt sind.

2. Lesekopf nach einem der vorhergehenden Ansprüche, wobei die Lichtquelle (2) zumindest eine lichtemittierende Struktur umfasst, die in einer Halbleiterzusammensetzung durch den Zusatz von Epitaxiestrukturen zu der Fläche des Substrats (4) hergestellt ist.

3. Lesekopf nach Anspruch 2, wobei die Lichtquelle (2) und ein Feld aus Fotodetektorelementen (3) in verschiedenen Schichten in den Epitaxiestrukturen angeordnet sind.

4. Lesekopf nach einem der vorhergehenden Ansprüche, wobei die Lichtquelle (2) zumindest eine lichtemittierende Struktur umfasst, die in einer Halbleiterzusammensetzung durch den Zusatz von zumindest einer Quantenschachtstruktur und Barriere- und Kontaktschichten zu dem Substrat hergestellt ist.

5. Lesekopf nach Anspruch 4, wobei die zumindest eine Quantenschachtstruktur so konfiguriert ist, Licht mit einer Wellenlänge zu emittieren, bei der der Fotodetektor innerhalb von 60% seiner Spitzenansprechfähigkeit liegt.

6. Lesekopf nach einem der vorhergehenden Ansprüche, wobei zumindest eine Rasterung (5, 6) an einem oder beiden Elementen des Fotodetektors (3) und der Lichtquelle (2) integriert ist.

7. Lesekopf nach Anspruch 6, wobei die zumindest eine Rasterung (5, 6) an der Seite der gitterangepassten Halbleiterzusammensetzung angeordnet ist, die sich benachbart einer Skala befindet, wenn der Lesekopf in der Skalenlesevorrichtung in Gebrauch ist.

8. Lesekopf nach einem der vorhergehenden Ansprüche, wobei die gitterangepasste Halbleiterzusammensetzung aus der III-V-Familie stammt.

9. Lesekopf nach Anspruch 8, wobei die gitterangepasste Halbleiterzusammensetzung Zusammensetzungen aus Indiumphosphid oder Galliumarsenid umfasst.

10. Lesekopf nach einem der vorhergehenden Ansprüche, wobei ein lichtemittierendes Element (21), das in die gitterangepasste Halbleiterzusammensetzung integriert ist, zur Erzeugung eines optischen Ausgangssignals von dem Lesekopf vorgesehen ist.

11. Lesekopf nach einem der vorhergehenden Ansprüche, wobei eine optische Faser (20) zur optischen Übertragung von Signalen von dem Lesekopf vorgesehen ist.

12. Lesekopf nach einem der vorhergehenden Ansprüche, wobei das Feld aus Fotodetektorelementen (3) in einem zweidimensionalen Feld verteilt ist.

13. Lesekopf nach einem der vorhergehenden Ansprüche, wobei das Feld aus Fotodetektorelementen (3) in einem diagonal gestreiften Muster oder Chevronmuster verteilt ist.

14. Lesekopf nach einem der vorhergehenden Ansprüche, wobei Fotodetektorelemente (3), die Signale gleicher Phase ausgeben, gemeinsam elektrisch verbunden sind.

15. Lesekopf nach einem der vorhergehenden Ansprüche, wobei der Lesekopf mit zumindest einem zusätzlichen Fotodetektorelement versehen ist, das in die gitterangepasste Halbleiterzusammensetzung zur Detektion verschiedener Merkmale von dem Feld aus Fotodetektorelementen integriert ist.

16. Lesekopf nach einem der vorhergehenden Ansprüche, wobei der Lesekopf mit zumindest einem zusätzlichen lichtemittierenden Element versehen ist, das in die gitterangepasste Halbleiterzusammensetzung zur Beleuchtung verschiedener Merkmale von der Lichtquelle integriert ist.

17. Lesekopf nach Anspruch 16, wobei die Achse, die die Zentren des zusätzlichen lichtemittierenden Elements und des zusätzlichen Fotodetektorelements verbindet, im Wesentlichen rechtwinklig zu der Richtung der Relativbewegung des Lesekopfes und einer Skala liegt.

18. Skalenlesevorrichtung, umfassend:
eine Skala (12); und
einen Lesekopf nach Anspruch 1.

## Revendications

1. Tête de lecture pour un appareil de lecture de règle, la tête de lecture comprenant une source lumineuse (2) et un réseau d'éléments photodétecteurs (3), dans laquelle ladite source lumineuse et ledit réseau d'éléments photodétecteurs sont fabriqués à partir d'un composé semi-conducteur en accord de maille (1), et dans laquelle la tête de lecture comprend au moins une grille (5, 6) située sur le composé semi-conducteur en accord de maille, dans laquelle ledit composé semi-conducteur en accord de maille formant la source lumineuse (2) est un réseau de photodétecteurs (3) est placé sur un substrat (4), et dans laquelle ledit substrat (4) est mis en accord de maille avec le composé semi-conducteur à partir duquel les éléments photodétecteurs (3) et la source lumineuse (2) sont fabriqués.

2. Tête de lecture selon l'une quelconque des revendications précédentes dans laquelle la source lumineuse (2) comprend au moins une structure électroluminescente fabriquée à partir d'un composé semi-conducteur par l'ajout de structures épitaxiales à la surface du substrat (4).

3. Tête de lecture selon la revendication 2, dans laquelle la source lumineuse (2) et le réseau d'éléments photodétecteurs (3) sont situés dans différentes couches des structures épitaxiales.

4. Tête de lecture selon l'une quelconque des revendications précédentes dans laquelle la source lumineuse (2) comprend au moins une structure électroluminescente fabriquée à partir d'un composé semi-conducteur par l'ajout d'au moins une structure de puits quantique et de couches barrière et contact au dit substrat.

5. Tête de lecture selon la revendication 4, dans laquelle la ou les structures de puits quantique sont configurées pour émettre de la lumière à la longueur d'onde à laquelle le photodétecteur se trouve à 60 % de son facteur de réponse maximum.

6. Tête de lecture selon l'une quelconque des revendications précédentes, la ou les dites grilles (5, 6) étant intégrées sur ledit photodétecteur (3) et/ou les dits éléments de source lumineuse (2).

7. Tête de lecture selon la revendication 6, dans laquelle la ou les grilles (5, 6) sont situées sur le côté du composé semi-conducteur en accord de maille qui est adjacent à une règle, quand la tête de lecture est utilisée dans un appareil de lecture de règle.

8. Tête de lecture selon l'une quelconque des revendications précédentes, dans laquelle le composé semi-conducteur en accord de maille est de la famille III-V.

9. Tête de lecture selon la revendication 8, dans laquelle le composé semi-conducteur en accord de maille comprend des composés de phosphure d'indium et d'arséniure de gallium.

10. Tête de lecture selon l'une quelconque des revendications précédentes, dans laquelle un élément électroluminescent (21) qui est intégré au composé semi-conducteur en accord de maille est fourni pour produire un signal optique en sortie de la tête de lecture.

11. Tête de lecture selon l'une quelconque des revendications précédentes, dans laquelle une fibre optique (20) est fournie pour la transmission optique des signaux venant de la tête de lecture.

12. Tête de lecture selon l'une quelconque des revendications précédentes, dans laquelle le réseau d'éléments photoconducteurs (3) est réparti en un réseau bidimensionnel.

13. Tête de lecture selon l'une quelconque des revendications précédentes, dans laquelle le réseau d'éléments photoconducteurs (3) est réparti en une structure de bandes diagonales ou de chevrons.

14. Tête de lecture selon l'une quelconque des revendications précédentes, dans laquelle les éléments photoconducteurs (3) produisant des signaux de phase similaire sont reliés électriquement en commun.

15. Tête de lecture selon l'une quelconque des revendications précédentes, dans laquelle la tête de lecture est dotée d'au moins un élément photodétecteur supplémentaire qui est intégré au composé semi-conducteur en accord de maille pour la détection de caractéristiques différentes à partir dudit réseau d'éléments photodétecteurs.

16. Tête de lecture selon l'une quelconque des revendications précédentes, dans laquelle la tête de lecture est dotée d'au moins un élément électroluminescent supplémentaire qui est intégré au composé semi-conducteur en accord de maille pour l'éclairage de différentes caractéristiques à partir de ladite source lumineuse.

17. Tête de lecture selon la revendication 16, dans laquelle l'axe joignant les centres dudit élément électroluminescent supplémentaire et dudit élément photodétecteur supplémentaire est sensiblement perpendiculaire à la direction du mouvement relatif de ladite tête de lecture et d'une règle.

18. Appareil de lecture de règle comprenant :
une règle (12) et une tête de lecture selon la revendication 1.
